# EUROPEAN PATENT APPLICATION

(11) **EP 4 827 264 A1**
(43) Date of publication of application: **21.10.2026**
(21) Application number: 24910253.4
(22) Date of filing: 28.10.2024
(51) Int. Cl.: H10B 53/30

(54) **STORAGE UNIT AND MANUFACTURING METHOD THEREFOR, FERROELECTRIC MEMORY, AND ELECTRONIC DEVICE**

(30) Priority: 27.12.2023 CN 202311831799
(71) Applicant: Huawei Technologies Co., Ltd., Shenzhen, Guangdong 518129 (CN)
(72) Inventor: DU, Kai, Shenzhen, Guangdong 518129 (CN); LV, Hangbing, Shenzhen, Guangdong 518129 (CN); CHEN, Zheng, Shenzhen, Guangdong 518129 (CN); PENG, Huayu, Shenzhen, Guangdong 518129 (CN); GU, Junxing, Shenzhen, Guangdong 518129 (CN); WANG, Chao, Shenzhen, Guangdong 518129 (CN)
(74) Representative: Goddar, Heinz J.
(86) International application number: PCT/CN2024/127789
(87) International publication number: WO 2025/139313

(57) **Abstract**

This application provides a memory cell, a manufacturing method thereof, a ferroelectric memory, and an electronic device, to improve performance of the ferroelectric memory. The memory cell includes a first electrode, a second electrode, and a ferroelectric layer, where the ferroelectric layer is located between the first electrode and the second electrode. A concentration of oxygen vacancies in the ferroelectric layer is distributed in a gradient manner in a first direction, and the first direction is a direction in which the first electrode points to the second electrode. In this embodiment of this application, the concentration of the oxygen vacancies in the ferroelectric layer is set to be distributed in the gradient manner in the first direction, so that a polarization orientation of a ferroelectric phase can also be distributed in the first direction. This greatly reduces randomness of the polarization orientation, improves uniformity of the polarization orientation of the ferroelectric phase in the ferroelectric layer, and further improves the performance of the ferroelectric memory.

## Description

### CROSS-REFERENCE TO RELATED APPLICATIONS

This application claims priority to Chinese Patent Application No. 202311831799.4, filed with the China National Intellectual Property Administration on December 27, 2023 and entitled "MEMORY CELL, MANUFACTURING METHOD THEREOF, FERROELECTRIC MEMORY, AND ELECTRONIC DEVICE", which is incorporated herein by reference in its entirety.

### TECHNICAL FIELD

This application relates to the field of storage technologies, and in particular, to a memory cell, a manufacturing method thereof, a ferroelectric memory, and an electronic device.

### BACKGROUND

Memories may be classified into volatile (volatile) memories and non-volatile (non-volatile) memories. A volatile dynamic random access memory (dynamic random access memory, DRAM) has advantages such as a high read/write speed and high durability, but the dynamic random access memory has a small storage capacity and high power consumption. With rapid development of the internet of things, big data, and artificial intelligence, a conventional dynamic random access memory cannot meet requirements.

A new ferroelectric memory has advantages such as a high speed, good durability, and non-volatility, and performance such as a storage capacity, power consumption, and the rate of the new ferroelectric memory is greatly improved compared with that of the conventional dynamic random access memory. A hafnium oxide-based ferroelectric memory has excellent polarization characteristics, good scalability, and high compatibility with a complementary metal oxide semiconductor (complementary metal oxide semiconductor, CMOS) process, and has a broad application prospect in the field of next-generation high-integration and low-power-consumption devices.

However, a hafnium oxide film prepared by using a mature atomic layer deposition (atomic layer deposition, ALD) process in the industry naturally presents a polycrystalline structure state, and crystallization phases and crystal orientations cannot be unified. Under current process conditions, a ferroelectric phase (O-phase) and another non-ferroelectric phase coexist in most hafnium oxide films, and a polarization orientation of the ferroelectric phase is randomly distributed. This severely affects performance of the hafnium oxide-based ferroelectric memory, and restricts further optimization and improvement of the performance of the hafnium oxide-based ferroelectric memory.

### SUMMARY

Embodiments of this application provide a memory cell, a manufacturing method thereof, a ferroelectric memory, and an electronic device, to improve performance of the ferroelectric memory.

According to a first aspect, an embodiment of this application provides a memory cell. The memory cell provided in this embodiment of this application may include a first electrode, a second electrode, and a ferroelectric layer, where the ferroelectric layer is located between the first electrode and the second electrode. A concentration of oxygen vacancies in the ferroelectric layer is distributed in a gradient manner in a first direction. The first direction is a direction in which the first electrode points to the second electrode. In this embodiment of this application, that the concentration of the oxygen vacancies in the ferroelectric layer is distributed in the gradient manner in the first direction may be understood as that the oxygen vacancies in the ferroelectric layer have a concentration difference in the first direction.

Because distribution of the concentration of the oxygen vacancies in the ferroelectric layer is correlated with a polarization orientation of a ferroelectric phase, a built-in electric field formed by an oxygen vacancy concentration difference has a strong template effect on the polarization orientation. Therefore, in this embodiment of this application, the concentration of the oxygen vacancies in the ferroelectric layer is set to be distributed in the gradient manner in the first direction, so that a built-in electric field consistent with the first direction can be formed. The formed built-in electric field can directly affect the polarization orientation of the ferroelectric phase, so that the polarization orientation of the ferroelectric phase can also be distributed in the first direction. This greatly reduces randomness of the polarization orientation, improves uniformity of the polarization orientation of the ferroelectric phase in the ferroelectric layer, and further improves performance of the ferroelectric memory.

The memory cell in this embodiment of this application may be a hafnium oxide-based ferroelectric memory cell. To be specific, the ferroelectric layer may include a hafnium oxide material. For example, the ferroelectric layer may include a zirconium-doped hafnium oxide (HfxZrl -xO, HZO) material. Certainly, in some cases, the memory cell in this embodiment of this application may alternatively be a ferroelectric memory cell including another ferroelectric material.

During specific implementation, the memory cell in this embodiment of this application may further include a substrate, and the substrate may be configured to carry the first electrode, the second electrode, and the ferroelectric layer. In this embodiment of this application, the first electrode may be located between the substrate and the ferroelectric layer, and the second electrode may be located on a side that is of the ferroelectric layer and that is away from the substrate. In some cases, the first electrode and the second electrode may be interchanged, and may be disposed based on an actual requirement.

The foregoing describes a basic structure of the memory cell in this embodiment of this application. The following describes in detail specific embodiments of the memory cell in this embodiment of this application.

### Embodiment 1

In some embodiments of this application, the first electrode and the second electrode may have different oxygen vacancy formation energies, and an oxygen vacancy concentration of the ferroelectric layer at a first interface is different from an oxygen vacancy concentration of the ferroelectric layer at a second interface. The first interface is an interface of contact between the ferroelectric layer and the first electrode, and the second interface is an interface of contact between the ferroelectric layer and the second electrode. The first electrode and the second electrode are set to have different oxygen vacancy formation energies, so that an oxygen vacancy concentration difference can be formed in the ferroelectric layer at the first interface and the second interface, and the concentration of the oxygen vacancies in the ferroelectric layer is distributed in a gradient manner in the first direction, thereby forming a uniform built-in electric field in the ferroelectric layer, improving uniformity of the polarization orientation of the ferroelectric phase in the ferroelectric layer, and improving the performance of the ferroelectric memory.

In a manufacturing process, the first electrode and the second electrode may be manufactured by using different chemical ratios, and a dangling bond that can absorb oxygen is formed in one of the electrodes, so that the first electrode and the second electrode have different oxygen vacancy formation energies. For example, a dangling bond that can absorb oxygen is formed in the second electrode. After the first electrode, the ferroelectric layer, and the second electrode are sequentially formed on the substrate, the ferroelectric layer is processed by using an annealing process, so that a ferroelectric material in the ferroelectric layer is crystallized. For example, the ferroelectric layer may be processed by using a rapid thermal annealing process. In the annealing process, the dangling bond in the second electrode may absorb oxygen atoms in the ferroelectric layer, so that more oxygen vacancies are formed in the ferroelectric layer at the second interface. Instead, the first electrode causes fewer oxygen vacancies in the ferroelectric layer at the first interface. Therefore, the oxygen vacancy concentration difference can be formed in the ferroelectric layer at the first interface and the second interface, to form the uniform built-in electric field in the ferroelectric layer. During specific implementation, the chemical ratios of the first electrode and the second electrode may be properly set based on specific materials of the first electrode and the second electrode.

In a possible implementation, the first electrode and the second electrode each may include a compound material. Specifically, the first electrode and the second electrode each may include a first element and a second element, where the first element is a metal element, and the second element is a non-metal element. An atomic count ratio of the first element to the second element in the first electrode is different from an atomic count ratio of the first element to the second element in the second electrode. In this way, an oxygen vacancy formation energy of the first electrode can be different an oxygen vacancy formation energy of the second electrode. During manufacturing, the first electrode and the second electrode may be manufactured by using different chemical ratios, so that the first electrode and the second electrode obtained through manufacturing are different in the atomic count ratio of the first element to the second element. For example, the first element may be an element like Ti, Ta, or Al, and the second element may be an element like N, P, or As. Optionally, the first electrode may include one or a combination of TiN, TaN, TiAlN, TiSiN, TaAlN, and TiAlCN, and the second electrode may include one or a combination of TiN, TaN, TiAlN, TiSiN, TaAlN, and TiAlCN.

In an embodiment, the first electrode and the second electrode may be made of a same material. For example, the first electrode and the second electrode each may include a TiN material, or the first electrode and the second electrode each may include a TaN material. In another embodiment, the first electrode and the second electrode may be made of different materials. For example, the first electrode may include a TiN material, and the second electrode may include a TaN material; or the first electrode may include a TiAlN material, and the second electrode may include a TiN material. During specific implementation, materials of the first electrode and the second electrode may be set based on an actual requirement. Examples are not provided herein one by one.

In another possible implementation, the first electrode may include a metal material, and the second electrode may include a compound material. For example, the first electrode may include metal materials such as metal W, Al, and Cu, and the second electrode may include a first element and a second element, where the first element is a metal element, and the second element is a non-metal element. For example, the first element may be another metal element like Ti, Ta, or Al, and the second element may include another non-metal material like N, P, or As. The second electrode may have a dangling bond of the first element; or the second electrode may have a dangling bond of the second element. In this way, the oxygen vacancy concentration of the ferroelectric layer at the first interface can be different from that at the second interface.

### Embodiment 2

In some other embodiments of this application, the ferroelectric layer may include at least two stacked ferroelectric films, and concentrations of oxygen vacancies in two adjacent ferroelectric films are different. During actual application, a quantity of layers and a distribution rule of the oxygen vacancy concentrations of ferroelectric films in the ferroelectric layer may be set based on an actual requirement. In this embodiment of this application, the at least two stacked ferroelectric films are disposed, and the concentrations of the oxygen vacancies in the two adjacent ferroelectric films are different, so that the concentration of the oxygen vacancies in the ferroelectric layer can be distributed in a gradient manner (or referred to as a chain distribution manner). Therefore, a uniform built-in electric field can be formed in the ferroelectric layer, and a direction of the built-in electric field is consistent with the first direction, so that a polarization direction of the ferroelectric phase is induced to be also distributed in the first direction.

In a manufacturing process, each ferroelectric film in the ferroelectric layer may be manufactured by using an atomic layer deposition (atomic layer deposition, ALD) process. In a process of depositing each ferroelectric film, ferroelectric films with different oxygen vacancy concentrations may be formed by controlling a dose of oxygen (O-dose). Specifically, the dose of oxygen may be adjusted by controlling parameters such as a residence time, a concentration, or a flow rate of oxygen. For example, when the ferroelectric layer includes a zirconium-doped hafnium oxide (HfxZr1-xO, HZO) material, a concentration of oxygen vacancies in the ferroelectric film may be controlled by adjusting parameters such as a residence time, a concentration, or a flow rate of an oxygen (O) element, a zirconium (Zr) element, or a hafnium (Hf) element.

In this embodiment of this application, a thickness of the ferroelectric layer may be within a range of 5 nm to 15 nm. For example, the thickness of the ferroelectric layer may be 5 nm, 8 nm, 10 nm, 12 nm, or 15 nm. A thickness of a single ferroelectric film may be 0.5 nm to 2 nm. For example, the thickness of the ferroelectric film may be 0.5 nm, 1 nm, 1.5 nm, or 2 nm.

In a possible implementation, oxygen vacancy concentrations of all ferroelectric films in the ferroelectric layer may be distributed in a high-low alternating manner in the first direction. For example, the oxygen vacancy concentrations of all the ferroelectric films in the ferroelectric layer may be distributed in a low-high-low-high-low-high or high-low-high-low-high-low rule in the first direction. In another possible implementation, oxygen vacancy concentrations of all ferroelectric films in the ferroelectric layer may be distributed in a rule of first decreasing and then increasing or first increasing and then decreasing in the first direction. During actual application, a quantity of layers and a distribution rule of the oxygen vacancy concentrations of the ferroelectric films in the ferroelectric layer may be set based on an actual requirement.

According to a second aspect, an embodiment of this application further provides a method for manufacturing a memory cell. The method for manufacturing a memory cell provided in this embodiment of this application may include the following steps:
step 1: forming a first electrode on a substrate;
step 2: depositing a ferroelectric layer on the first electrode;
step 3: forming a second electrode on the ferroelectric layer, where the first electrode and the second electrode have different oxygen vacancy formation energies; and
step 4: processing the ferroelectric layer by using an annealing process, to enable oxygen elements in the ferroelectric layer to move in a first direction, so as to enable a concentration of oxygen vacancies in the ferroelectric layer to be distributed in a gradient manner in the first direction, where the first direction is a direction in which the first electrode points to the second electrode.

In this embodiment of this application, the first electrode and the second electrode with different oxygen vacancy formation energies are manufactured. In the subsequent annealing process, an electrode with a higher oxygen vacancy formation energy may absorb the oxygen elements in the ferroelectric layer, so that the oxygen elements in the ferroelectric layer move in the first direction, and the concentration of the oxygen vacancies in the ferroelectric layer is distributed in the gradient manner in the first direction. In this way, a uniform built-in electric field is formed in the ferroelectric layer, thereby improving uniformity of a polarization orientation of a ferroelectric phase in the ferroelectric layer and improving performance of the ferroelectric memory.

The memory cell in this embodiment of this application may be a hafnium oxide-based ferroelectric memory cell. In step 2, the ferroelectric layer may be made of a hafnium oxide material. For example, the ferroelectric layer may be made of a zirconium-doped hafnium oxide (HfxZr1-xO, HZO) material. Certainly, in some cases, the ferroelectric layer may alternatively be made of another ferroelectric material. In a possible implementation, the ferroelectric layer may be manufactured by using an atomic layer deposition (atomic layer deposition, ALD) process.

In step 1 and step 3, the first electrode and the second electrode may be manufactured by using different chemical ratios, and a dangling bond that can absorb oxygen is formed in one of the electrodes, so that the first electrode and the second electrode have different oxygen vacancy formation energies. For example, a dangling bond that can absorb oxygen is formed in the second electrode. In step 4, the ferroelectric layer is processed by using the annealing process, so that a ferroelectric material in the ferroelectric layer is crystallized. For example, the ferroelectric layer may be processed by using a rapid thermal annealing process. In the annealing process, the dangling bond in the second electrode may absorb oxygen atoms in the ferroelectric layer, so that more oxygen vacancies are formed in the ferroelectric layer at a second interface. Instead, the first electrode causes fewer oxygen vacancies in the ferroelectric layer at a first interface. Therefore, an oxygen vacancy concentration difference can be formed in the ferroelectric layer, at the first interface and the second interface to form the uniform built-in electric field in the ferroelectric layer.

The memory cell in Embodiment 1 of the first aspect may be manufactured by using the manufacturing method according to the second aspect. For a specific implementation of the manufacturing method according to the second aspect, refer to the specific implementation of the memory cell in Embodiment 1 of the first aspect. Repeated parts are not described herein again.

According to a third aspect, an embodiment of this application further provides a method for manufacturing a memory cell. The method for manufacturing a memory cell provided in this embodiment of this application may include the following steps:
step (1): forming a first electrode on a substrate;
step (2): sequentially depositing at least two ferroelectric films on the first electrode, and making concentrations of oxygen vacancies in two adjacent ferroelectric films different; and
step (3): forming a second electrode on the at least two ferroelectric films.

In this embodiment of this application, the at least two ferroelectric films are sequentially deposited on the first electrode, and the concentrations of the oxygen vacancies in the two adjacent ferroelectric films are different, so that a concentration of oxygen vacancies in a ferroelectric layer can be distributed in a gradient manner. Therefore, a uniform built-in electric field can be formed in the ferroelectric layer, and a direction of the built-in electric field is consistent with a first direction (a direction in which the first electrode points to the second electrode), so that a polarization direction of a ferroelectric phase is induced to be also distributed in the first direction.

The memory cell in this embodiment of this application may be a hafnium oxide-based ferroelectric memory cell. In step (2), each ferroelectric film in the ferroelectric layer may be made of a hafnium oxide material. For example, the ferroelectric film may be made of a zirconium-doped hafnium oxide (HfxZr1-xO, HZO) material. Certainly, in some cases, the ferroelectric film may alternatively be made of another ferroelectric material.

In step (2), each ferroelectric film may be manufactured by using an atomic layer deposition (atomic layer deposition, ALD) process. In a process of depositing each ferroelectric film, ferroelectric films with different oxygen vacancy concentrations may be formed by controlling a dose of oxygen (O-dose). Specifically, the dose of oxygen may be adjusted by controlling parameters such as a residence time, a concentration, or a flow rate of oxygen. For example, when the ferroelectric layer includes a zirconium-doped hafnium oxide (HfxZr1-xO, HZO) material, a concentration of oxygen vacancies in the ferroelectric film may be controlled by adjusting parameters such as a residence time, a concentration, or a flow rate of an oxygen (O) element, a zirconium (Zr) element, or a hafnium (Hf) element.

Specifically, in step (2), a thickness of a single deposited ferroelectric film may be 0.5 nm to 2 nm. For example, the thickness of the ferroelectric film may be 0.5 nm, 1 nm, 1.5 nm, or 2 nm. A total thickness of the ferroelectric layer obtained by stacking all ferroelectric films may be within a range of 5 nm to 15 nm. For example, the total thickness of the ferroelectric layer may be 5 nm, 8 nm, 10 nm, 12 nm, or 15 nm.

In a possible implementation, oxygen vacancy concentrations of all ferroelectric films in the ferroelectric layer may be distributed in a high-low alternating manner in the first direction. For example, the oxygen vacancy concentrations of all the ferroelectric films in the ferroelectric layer may be distributed in a low-high-low-high-low-high or high-low-high-low-high-low rule in the first direction. In another possible implementation, oxygen vacancy concentrations of all ferroelectric films in the ferroelectric layer may be distributed in a rule of first decreasing and then increasing or first increasing and then decreasing in the first direction. During actual application, a quantity of layers and a distribution rule of the oxygen vacancy concentrations of the ferroelectric films in the ferroelectric layer may be set based on an actual requirement.

The memory cell in Embodiment 2 of the first aspect may be manufactured by using the manufacturing method according to the third aspect. For a specific implementation of the manufacturing method according to the third aspect, refer to the specific implementation of the memory cell in Embodiment 2 of the first aspect. Repeated parts are not described herein again.

According to a fourth aspect, an embodiment of this application further provides a ferroelectric memory. The ferroelectric memory in this embodiment of this application may be a hafnium oxide-based ferroelectric memory. Certainly, the ferroelectric memory in this embodiment of this application may alternatively be a ferroelectric memory including another ferroelectric material. The ferroelectric memory in this embodiment of this application may be any type of memory, for example, a ferroelectric random access memory (ferroelectric random access memory, FeRAM or FRAM), a ferroelectric field effect transistor (ferroelectric field effect transistor, FeFET) memory, or a ferroelectric tunnel junction (ferroelectric tunnel junction, FTJ) memory.

The ferroelectric memory provided in this embodiment of this application may include a controller and any memory cell in the first aspect, where the memory cell is electrically connected to the controller. Because the uniformity of the polarization orientation of the ferroelectric phase in the memory cell in the first aspect is high, performance of the ferroelectric memory including the memory cell is good.

According to a fifth aspect, an embodiment of this application further provides an electronic device. The electronic device in this embodiment of this application may be any electronic device having a storage function. For example, the electronic device in this embodiment of this application may be a mobile phone, a tablet computer, a desktop computer, an intelligent wearable device, a vehicle-mounted device, a server, a processor, or the like.

The electronic device provided in this embodiment of this application may include a circuit board and any ferroelectric memory in the fourth aspect, where the ferroelectric memory is electrically connected to the circuit board. Because the ferroelectric memory in the fourth aspect has high performance, performance of the electronic device including the ferroelectric memory is also good.

### BRIEF DESCRIPTION OF DRAWINGS

FIG. 1 is a diagram of a structure of a memory cell according to an embodiment of this application;
FIG. 2A and FIG. 2B are a comparison diagram of a relationship between concentration distribution of oxygen vacancies and polarization orientations of ferroelectric domains;
FIG. 3 is another diagram of a structure of a memory cell according to an embodiment of this application;
FIG. 4A to FIG. 4C are a diagram of a chemical ratio of a first electrode and a chemical ratio of a second electrode according to an embodiment of this application;
FIG. 5A and FIG. 5B are another diagram of a chemical ratio of a first electrode and a chemical ratio of a second electrode according to an embodiment of this application;
FIG. 6A is another diagram of a structure of a memory cell according to an embodiment of this application;
FIG. 6B shows a comparative embodiment of a memory cell according to an embodiment of this application;
FIG. 7A and FIG. 7B are a diagram of a structure of a ferroelectric layer according to an embodiment of this application;
FIG. 8A and FIG. 8B are another diagram of a structure of a ferroelectric layer according to an embodiment of this application;
FIG. 9A and FIG. 9B are another diagram of a structure of a ferroelectric layer according to an embodiment of this application;
FIG. 10 is a flowchart of a method for manufacturing a memory cell according to an embodiment of this application; and
FIG. 11 is a flowchart of another method for manufacturing a memory cell according to an embodiment of this application.

### Reference numerals:

10: substrate; 11: first electrode; 12: second electrode; 13: ferroelectric layer; 131: ferroelectric film; E: built-in electric field; P: polarization orientation; F1: first direction; Q1: first interface; and Q2: second interface.

### DESCRIPTION OF EMBODIMENTS

A new ferroelectric memory has advantages such as a high speed, good durability, and non-volatility, and performance such as a storage capacity, power consumption, and the rate of the new ferroelectric memory is greatly improved compared with that of a conventional dynamic random access memory. A hafnium oxide-based ferroelectric memory has excellent polarization characteristics, good scalability, and high compatibility with a complementary metal oxide semiconductor (complementary metal oxide semiconductor, CMOS) process, and has a broad application prospect in the field of next-generation high-integration and low-power-consumption devices.

However, a hafnium oxide film prepared by using a mature atomic layer deposition (atomic layer deposition, ALD) process in the industry naturally presents a polycrystalline structure state, and crystallization phases and crystal orientations cannot be unified. Under current process conditions, a ferroelectric phase (O-phase) and another non-ferroelectric phase coexist in most hafnium oxide films, and a polarization orientation of the ferroelectric phase is randomly distributed. As the hafnium oxide-based ferroelectric memory gradually develops towards high integration and miniaturization, a size of the hafnium oxide-based ferroelectric memory becomes smaller, and uniformity of a polarization orientation of a ferroelectric phase becomes poorer. As a result, a difference between threshold voltages corresponding to a write (program) operation and an erase (erase) operation becomes smaller, and a distinction between the write operation and the erase operation is small. This severely affects performance of the hafnium oxide-based ferroelectric memory, and restricts further optimization and improvement of the performance of the hafnium oxide-based ferroelectric memory.

In view of this, embodiments of this application provide a memory cell, a manufacturing method thereof, a ferroelectric memory, and an electronic device, to improve performance of the ferroelectric memory. The ferroelectric memory in embodiments of this application may be a hafnium oxide-based ferroelectric memory. Certainly, the ferroelectric memory in embodiments of this application may alternatively be a ferroelectric memory including another ferroelectric material. The ferroelectric memory in embodiments of this application may be any type of memory, for example, a ferroelectric random access memory (ferroelectric random access memory, FeRAM or FRAM), a ferroelectric field effect transistor (ferroelectric field effect transistor, FeFET) memory, or a ferroelectric tunnel junction (ferroelectric tunnel junction, FTJ) memory. The ferroelectric memory provided in embodiments of this application may be applied to various electronic devices having a storage function, for example, may be applied to electronic devices such as a mobile phone, a tablet computer, a desktop computer, an intelligent wearable device, a vehicle-mounted device, a server, or a processor.

To make the objectives, technical solutions, and advantages of this application clearer, the following further describes this application in detail with reference to the accompanying drawings.

It should be noted that same reference numerals in the accompanying drawings of this application represent same or similar structures. Therefore, repeated descriptions thereof are omitted. Expressions of positions and directions in this application are described by using the accompanying drawings as an example. However, changes may also be made as required, and all the changes fall within the protection scope of this application. The accompanying drawings in this application are merely used to illustrate relative position relationships and do not represent an actual scale.

In descriptions of this application, it should be noted that orientation or position relationships indicated by terms "center", "above", "below", "left", "right", "vertical", "horizontal", "inner", "outer", and the like are orientation or position relationships based on the accompanying drawings, and are merely intended for conveniently describing this application and simplifying descriptions, rather than indicating or implying that an apparatus or an element in question needs to have a specific orientation or needs to be constructed and operated in a specific orientation, and therefore cannot be construed as a limitation on this application. In addition, terms "first" and "second" are merely used for a purpose of description, and shall not be understood as an indication or implication of relative importance.

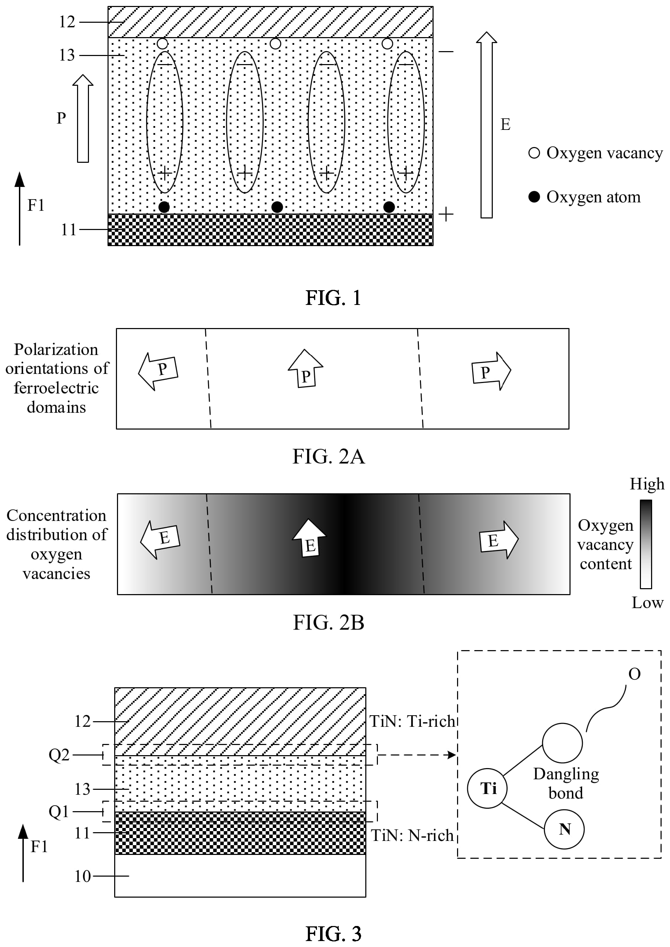

FIG. 1 is a diagram of a structure of a memory cell according to an embodiment of this application. As shown in FIG. 1, the memory cell provided in this embodiment of this application may include a first electrode 11, a second electrode 12, and a ferroelectric layer 13, where the ferroelectric layer 13 is located between the first electrode 11 and the second electrode 12. A concentration of oxygen vacancies in the ferroelectric layer 13 is distributed in a gradient manner in a first direction F1. The first direction F1 is a direction in which the first electrode 11 points to the second electrode 12, and the first direction F1 may be a vertical upward direction shown in FIG. 1, or may be a vertical downward direction. In this embodiment of this application, that the concentration of the oxygen vacancies in the ferroelectric layer 13 is distributed in the gradient manner in the first direction F1 may be understood as that the oxygen vacancies in the ferroelectric layer 13 have a concentration difference in the first direction F1. For example, in FIG. 1, a white circle represents an oxygen vacancy, and a black circle represents an oxygen atom. The ferroelectric layer 13 has more oxygen vacancies and a higher oxygen vacancy concentration at a position close to the second electrode 12, and the ferroelectric layer 13 has more oxygen atoms and a lower oxygen vacancy concentration at a position close to the first electrode 11. The oxygen vacancies in the ferroelectric layer 13 have a concentration difference in the first direction F1, and the concentration of the oxygen vacancies is distributed in the gradient manner in the first direction F1.

The memory cell in this embodiment of this application may be a hafnium oxide-based ferroelectric memory cell. To be specific, the ferroelectric layer 13 may include a hafnium oxide material. For example, the ferroelectric layer 13 may include a zirconium-doped hafnium oxide (HfxZr1-xO, HZO) material. Certainly, in some cases, the memory cell in this embodiment of this application may alternatively be a ferroelectric memory cell including another ferroelectric material.

FIG. 2A and FIG. 2B are a comparison diagram of a relationship between concentration distribution of oxygen vacancies and polarization orientations of ferroelectric domains. FIG. 2A is a diagram of the polarization orientations of the ferroelectric domains, and FIG. 2B is a diagram of the concentration distribution of the oxygen vacancies. As shown in FIG. 2A and FIG. 2B, different ferroelectric domains are located on two sides of a dashed line in FIG. 2A and FIG. 2B. It can be learned from FIG. 2A that polarization orientations P in a same ferroelectric domain are basically consistent, and polarization orientations P in different ferroelectric domains are random. It can be learned from FIG. 2B that the concentrations of the oxygen vacancies are distributed in a gradient manner from high to low (as shown in the figure, the filling color is from dark to light), and an oxygen vacancy concentration difference may form a built-in electric field E. It can be clearly learned by comparing FIG. 2A with FIG. 2B that, although the polarization orientations P of the different ferroelectric domains and the concentration distribution of the oxygen vacancies are random to some extent, distribution of the polarization orientations P of the different ferroelectric domains is basically consistent with directions of built-in electric fields E in the different ferroelectric domains. The built-in electric field E has a strong template effect on the polarization orientation P. Therefore, concentration distribution of oxygen vacancies in a ferroelectric phase can directly affect a polarization orientation P.

With reference to FIG. 1 and FIG. 2A and FIG. 2B, because distribution of the concentration of the oxygen vacancies in the ferroelectric layer 13 is correlated with the polarization orientation P of the ferroelectric phase, a built-in electric field E formed by an oxygen vacancy concentration difference has a strong template effect on the polarization orientation P. Therefore, in this embodiment of this application, the concentration of the oxygen vacancies in the ferroelectric layer 13 is set to be distributed in the gradient manner in the first direction F1, so that a built-in electric field E consistent with the first direction F1 can be formed. The formed built-in electric field E can directly affect the polarization orientation P of the ferroelectric phase, so that the polarization orientation P of the ferroelectric phase can also be distributed in the first direction F1. This greatly reduces randomness of the polarization orientation P, improves uniformity of the polarization orientation P of the ferroelectric phase in the ferroelectric layer 13, and further improves performance of the ferroelectric memory.

The foregoing describes a basic structure of the memory cell in this embodiment of this application. The following describes in detail specific embodiments of the memory cell in this embodiment of this application with reference to the accompanying drawings.

### Embodiment 1

FIG. 3 is another diagram of the structure of the memory cell according to an embodiment of this application. As shown in FIG. 3, in some embodiments of this application, the first electrode 11 and the second electrode 12 may have different oxygen vacancy formation energies, and an oxygen vacancy concentration of the ferroelectric layer 13 at a first interface Q1 is different from an oxygen vacancy concentration of the ferroelectric layer 13 at a second interface Q2. The first interface Q1 is an interface of contact between the ferroelectric layer 13 and the first electrode 11, and the second interface Q2 is an interface of contact between the ferroelectric layer 13 and the second electrode 12. The first electrode 11 and the second electrode 12 are set to have different oxygen vacancy formation energies, so that an oxygen vacancy concentration difference can be formed in the ferroelectric layer 13 at the first interface Q1 and the second interface Q2, and the concentration of the oxygen vacancies in the ferroelectric layer 13 is distributed in a gradient manner in the first direction F1, thereby forming a uniform built-in electric field in the ferroelectric layer 13, improving uniformity of the polarization orientation of the ferroelectric phase in the ferroelectric layer 13, and improving the performance of the ferroelectric memory.

During specific implementation, the memory cell in this embodiment of this application may further include a substrate 10. The substrate 10 may be used to carry the first electrode 11, the second electrode 12, and the ferroelectric layer 13. In the accompanying drawings of this application, an example in which the first electrode 11 is located between the substrate 10 and the ferroelectric layer 13 and the second electrode 12 is located on a side that is of the ferroelectric layer 13 and that is away from the substrate 10 is used for illustration. In some cases, the first electrode 11 and the second electrode 12 may be interchanged, and may be disposed based on an actual requirement.

In a manufacturing process, the first electrode 11 and the second electrode 12 may be manufactured by using different chemical ratios, and a dangling bond that can absorb oxygen is formed in one of the electrodes, so that the first electrode 11 and the second electrode 12 have different oxygen vacancy formation energies. For example, a dangling bond that can absorb oxygen is formed in the second electrode 12. After the first electrode 11, the ferroelectric layer 13, and the second electrode 12 are sequentially formed on the substrate 10, the ferroelectric layer 13 is processed by using an annealing process, so that a ferroelectric material in the ferroelectric layer 13 is crystallized. For example, the ferroelectric layer 13 may be processed by using a rapid thermal annealing process. In the annealing process, the dangling bond in the second electrode 12 may absorb oxygen atoms in the ferroelectric layer 13, so that more oxygen vacancies are formed in the ferroelectric layer 13 at the second interface Q2. Instead, the first electrode 11 causes fewer oxygen vacancies in the ferroelectric layer 13 at the first interface Q1. Therefore, the oxygen vacancy concentration difference can be formed in the ferroelectric layer 13 at the first interface Q1 and the second interface Q2, to form the uniform built-in electric field in the ferroelectric layer 13.

In a possible implementation, the first electrode 11 and the second electrode 12 each may include a first element and a second element, the first element is a metal element, and the second element is a non-metal element. An atomic count ratio of the first element to the second element in the first electrode 11 is different from an atomic count ratio of the first element to the second element in the second electrode 12. In this way, an oxygen vacancy formation energy of the first electrode 11 can be different an oxygen vacancy formation energy of the second electrode 12. During manufacturing, the first electrode 11 and the second electrode 12 may be manufactured by using different chemical ratios, so that the first electrode 11 and the second electrode 12 obtained through manufacturing are different in the atomic count ratio of the first element to the second element. For example, the first element may be an element like Ti, Ta, or Al, and the second element may be an element like N, P, or As. Optionally, the first electrode 11 may include one or a combination of TiN, TaN, TiAlN, TiSiN, TaAlN, and TiAlCN, and the second electrode 12 may include one or a combination of TiN, TaN, TiAlN, TiSiN, TaAlN, and TiAlCN.

In an embodiment, the first electrode 11 and the second electrode 12 may be made of a same material. Still refer to FIG. 3. For example, the first electrode 11 and the second electrode 12 each include a TiN material, that is, the first element may be Ti, and the second element may be N. When the first electrode 11 and the second electrode 12 are manufactured, chemical ratios of the Ti element to the N element may be different. For example, when the first electrode 11 is manufactured, an atomic count ratio of the Ti element to the N element may be lower than a target ratio, and when the second electrode 12 is manufactured, an atomic count ratio of the Ti element to the N element may be higher than the target ratio. The target ratio may be a ratio at which the Ti element and the N element completely react with each other exactly. In other words, there are more N elements in the first electrode 11, and there are more Ti elements in the second electrode 12. In this way, there is a Ti dangling bond in the second electrode 12 obtained through manufacturing. In a subsequent process of processing the ferroelectric layer 13 by using the annealing process, the Ti dangling bond absorbs oxygen from the ferroelectric layer 13, so that oxygen vacancy content of the ferroelectric layer 13 at the second interface Q2 is higher. Instead, there are more N elements in the first electrode 11 obtained through manufacturing, and the oxygen vacancy content of the ferroelectric layer 13 at the first interface Q1 is reduced, so that the oxygen vacancy concentration of the ferroelectric layer 13 at the first interface Q1 is different from that at the second interface Q2.

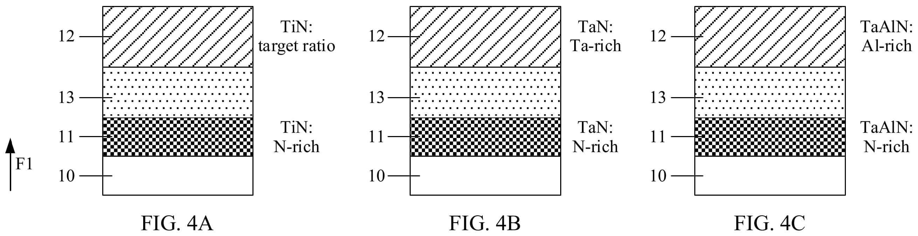

FIG. 4A to FIG. 4C are a diagram of a chemical ratio of a first electrode and a chemical ratio of a second electrode according to an embodiment of this application. For example, as shown in FIG. 4A, the first electrode 11 and the second electrode 12 each may include a TiN material, that is, the first element may be Ti, and the second element may be N. In a manufacturing process, when the first electrode 11 is manufactured, an atomic count ratio of the Ti element to the N element may be lower than a target ratio, and when the second electrode 12 is manufactured, an atomic count ratio of the Ti element to the N element may be approximately equal to the target ratio. In other words, there are more N elements in the first electrode 11, and there are basically no redundant Ti elements and N elements in the second electrode 12. In this way, oxygen vacancy content of the ferroelectric layer 13 obtained through manufacturing at the second interface Q2 can be higher. As shown in FIG. 4B, the first electrode 11 and the second electrode 12 each may include a TaN material, that is, the first element may be Ta, and the second element may be N. In a manufacturing process, an atomic count ratio of the Ta element to the N element when the first electrode 11 is manufactured is lower than an atomic count ratio of the Ta element to the N element when the second electrode 12 is manufactured. In other words, there are more N elements in the first electrode 11, and there are more Ta elements in the second electrode 12. In this way, oxygen vacancy content of the ferroelectric layer 13 obtained through manufacturing at the second interface Q2 can be higher. As shown in FIG. 4C, the first electrode 11 and the second electrode 12 each may include a TaAlN material, that is, the first element may be Al, and the second element may be N. In a manufacturing process, an atomic count ratio of the Al element to the N element when the first electrode 11 is manufactured is lower than an atomic count ratio of the Al element to the N element when the second electrode 12 is manufactured. In this way, oxygen vacancy content of the ferroelectric layer 13 obtained through manufacturing at the second interface Q2 can be higher.

In another embodiment, the first electrode 11 and the second electrode 12 may be made of different materials. For example, the first electrode 11 may include a TiN material, and the second electrode 12 may include a TaN material; or the first electrode 11 may include a TiAlN material, and the second electrode 12 may include a TiN material. During specific implementation, materials of the first electrode 11 and the second electrode 12 may be set based on an actual requirement. Examples are not provided herein one by one.

The foregoing describes, with reference to FIG. 3 and FIG. 4A to FIG. 4C, specific implementations of manufacturing the first electrode 11 and the second electrode 12 by using different chemical ratios. During specific implementation, the chemical ratio of the first electrode 11 and the chemical ratio of the second electrode 12 may be properly set based on specific materials of the first electrode 11 and the second electrode 12. Examples are not provided herein one by one. In the embodiments shown in FIG. 3 and FIG. 4A to FIG. 4C, an example in which the oxygen vacancy concentration of the ferroelectric layer 13 at the first interface Q1 is lower than the oxygen vacancy concentration at the second interface Q2 is used for illustration. During specific implementation, the oxygen vacancy concentration of the ferroelectric layer 13 at the first interface Q1 may alternatively be higher than the oxygen vacancy concentration at the second interface Q2, provided that the concentration of the oxygen vacancies in the ferroelectric layer 13 can be distributed in a gradient manner in the first direction F1.

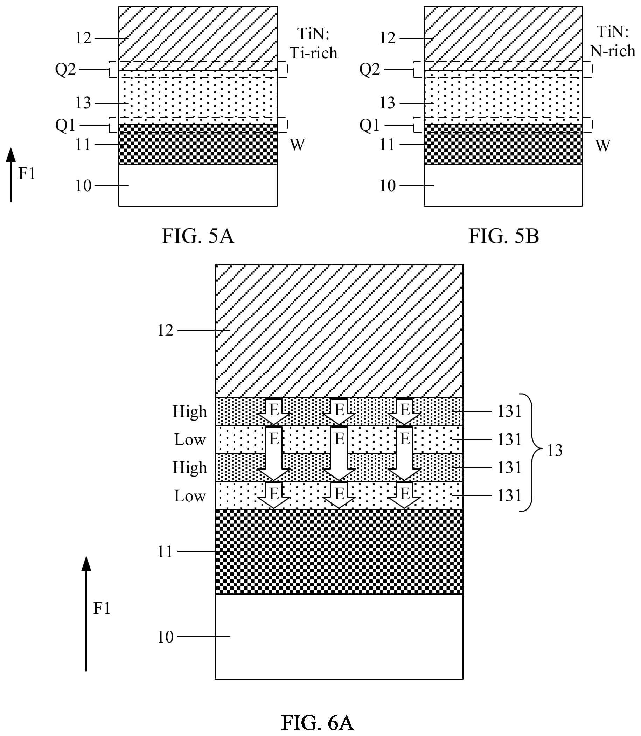

In the foregoing embodiment, an example in which the first electrode and the second electrode each include a compound material is used for description. In another possible implementation, the first electrode may include a metal material, and the second electrode may include a compound material. FIG. 5A and FIG. 5B are another diagram of a chemical ratio of a first electrode and a chemical ratio of a second electrode according to an embodiment of this application. As shown in FIG. 5A and FIG. 5B, the first electrode 11 may include a metal material. For example, the first electrode 11 may include a metal W. Certainly, the first electrode 11 may further include another metal material like Al or Cu. The second electrode 12 may include a first element and a second element, where the first element is a metal element, and the second element is a non-metal element. For example, the first element may be Ti, and the second element may be N. Certainly, the first element may further include another metal element like Ta or Al, and the second element may further include another non-metal material like P or As.

As shown in FIG. 5A, the second electrode 12 may have a dangling bond of the first element. In a manufacturing process, when the second electrode 12 is manufactured, an atomic count ratio of the first element to the second element is greater than a target ratio, so that the second electrode 12 obtained through manufacturing has higher content of the first element. The second electrode 12 has the dangling bond of the first element, so that in an annealing process, the dangling bond of the first element can absorb oxygen in the ferroelectric layer 13, and the oxygen vacancy concentration of the ferroelectric layer 13 at the second interface Q2 is higher than the oxygen vacancy concentration of the ferroelectric layer 13 at the first interface Q1. For example, in the figure, the second electrode 12 includes a TiN material. In a process of manufacturing the second electrode 12, an atomic count ratio of the Ti element to the N element may be greater than a target ratio, so that there is a Ti dangling bond in the second electrode 12 obtained through manufacturing. In an annealing process, the Ti dangling bond may absorb oxygen in the ferroelectric layer 13, so that the oxygen vacancy concentration of the ferroelectric layer 13 at the second interface Q2 is higher.

As shown in FIG. 5B, the second electrode 12 may have a dangling bond of the second element. In a manufacturing process, when the second electrode 12 is manufactured, an atomic count ratio of the first element to the second element is less than a target ratio, so that the second electrode 12 obtained through manufacturing has high content of the second element. The second electrode 12 has the dangling bond of the second element, so that in an annealing process, the dangling bond of the second element can reduce the oxygen vacancy concentration, and the oxygen vacancy concentration of the ferroelectric layer 13 at the second interface Q2 is lower than the oxygen vacancy concentration at the first interface Q1. An example in which the second electrode 12 includes a TiN material is still used. In a process of manufacturing the second electrode 12, an atomic count ratio of the Ti element to the N element may be less than the target ratio, so that there is an N dangling bond in the second electrode 12 obtained through manufacturing. In an annealing process, the N dangling bond reduces the oxygen vacancy concentration, so that the oxygen vacancy concentration of the ferroelectric layer 13 at the second interface Q2 is lower.

In FIG. 5A and FIG. 5B, an example in which the first electrode 11 includes a metal material and the second electrode 12 includes a compound material is used. During specific implementation, alternatively, the first electrode 11 may be set to include a compound material, and the second electrode 12 may be set to include a metal material.

### Embodiment 2

FIG. 6A is another diagram of the structure of the memory cell according to an embodiment of this application. As shown in FIG. 6A, in some other embodiments of this application, the ferroelectric layer 13 may include at least two stacked ferroelectric films 131, and concentrations of oxygen vacancies in two adjacent ferroelectric films 131 are different. For example, in FIG. 6A, the ferroelectric layer 13 includes four ferroelectric films 131, and oxygen vacancy concentrations of all ferroelectric films 131 in the ferroelectric layer 13 are distributed in a high-low-high-low rule in the first direction F1 (for example, downward in the first direction F1). During actual application, a quantity of layers and a distribution rule of the oxygen vacancy concentrations of the ferroelectric films 131 in the ferroelectric layer 13 may be set based on an actual requirement. In this embodiment of this application, the at least two stacked ferroelectric films 131 are disposed, and the concentrations of the oxygen vacancies in the two adjacent ferroelectric films 131 are different, so that the concentration of the oxygen vacancies in the ferroelectric layer 13 can be distributed in a gradient manner (or referred to as a chain distribution manner). Therefore, a uniform built-in electric field E can be formed in the ferroelectric layer 13, and a direction of the built-in electric field E is consistent with the first direction F1, so that a polarization direction of the ferroelectric phase is induced to be also distributed in the first direction F1.

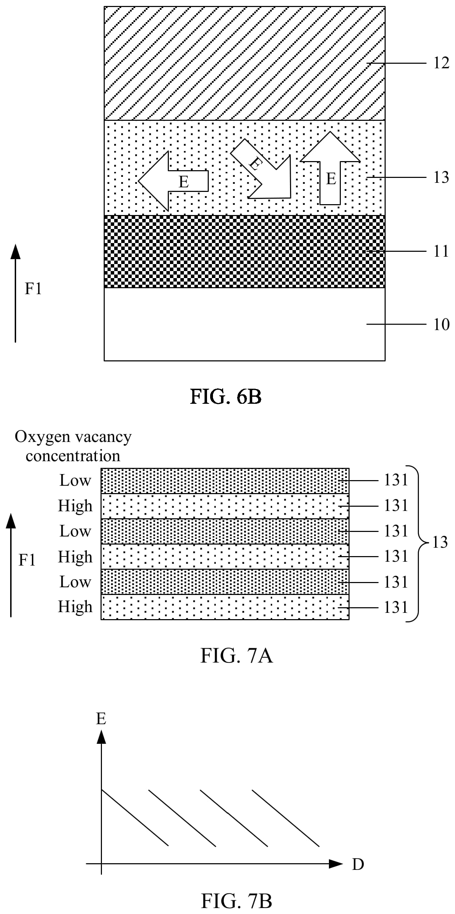

FIG. 6B shows a comparative embodiment of the memory cell according to an embodiment of this application. As shown in FIG. 6B, when the concentration of the oxygen vacancies in the ferroelectric layer 13 is uniform, the built-in electric field E formed in the ferroelectric layer 13 is randomly distributed, and the polarization orientation of the ferroelectric phase is also randomly distributed. It can be learned by comparing FIG. 6A with FIG. 6B that, compared with the technical solution in which the concentration of the oxygen vacancies in the ferroelectric layer 13 is uniform, in this embodiment of this application, the at least two stacked ferroelectric films 131 are disposed, and the concentrations of the oxygen vacancies in the two adjacent ferroelectric films 131 are different, so that the concentration of the oxygen vacancies in the ferroelectric layer 13 can be distributed in the gradient manner in the first direction F1. In this way, the built-in electric field E formed by the oxygen vacancy concentration difference is more uniformly distributed in the first direction F1, and the polarization direction of the ferroelectric phase can be induced to be distributed in the first direction F1.

In a manufacturing process, each ferroelectric film 131 in the ferroelectric layer 13 may be manufactured by using an atomic layer deposition (atomic layer deposition, ALD) process. In a process of depositing each ferroelectric film 131, ferroelectric films 131 with different oxygen vacancy concentrations may be formed by controlling a dose of oxygen (O-dose). Specifically, the dose of oxygen may be adjusted by controlling parameters such as a residence time, a concentration, or a flow rate of oxygen. For example, when the ferroelectric layer 13 includes a zirconium-doped hafnium oxide (HfxZrl-xO, HZO) material, a concentration of oxygen vacancies in the ferroelectric film 131 may be controlled by adjusting parameters such as a residence time, a concentration, or a flow rate of an oxygen (O) element, a zirconium (Zr) element, or a hafnium (Hf) element.

In this embodiment of this application, a thickness of the ferroelectric layer 13 may be within a range of 5 nm to 15 nm. For example, the thickness of the ferroelectric layer 13 may be 5 nm, 8 nm, 10 nm, 12 nm, or 15 nm. A thickness of a single ferroelectric film 131 may be 0.5 nm to 2 nm. For example, the thickness of the ferroelectric film 131 may be 0.5 nm, 1 nm, 1.5 nm, or 2 nm.

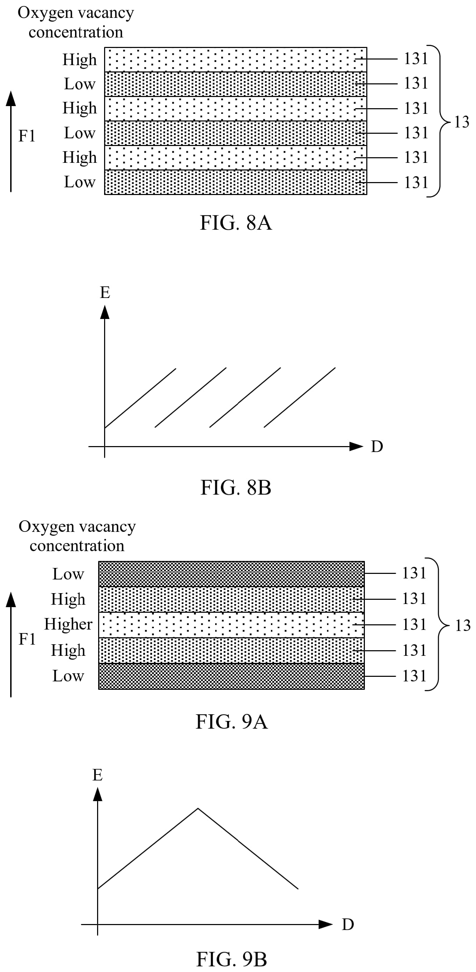

FIG. 7A and FIG. 7B are a diagram of a structure of a ferroelectric layer according to an embodiment of this application. FIG. 7A is a diagram of a distribution rule of oxygen vacancy concentrations of all ferroelectric films in the ferroelectric layer. FIG. 7B is a diagram of built-in electric field strength at different positions in the ferroelectric layer. In the figure, a vertical coordinate E represents built-in electric field strength, and a horizontal coordinate D represents a distance to a lower surface of the ferroelectric layer (a surface that is of the ferroelectric layer and that is close to a side of the first electrode). As shown in FIG. 7A and FIG. 7B, in a possible implementation, the oxygen vacancy concentrations of all the ferroelectric films 131 in the ferroelectric layer 13 may be distributed in a high-low alternating manner in the first direction F1. For example, in FIG. 7A and FIG. 7B, the oxygen vacancy concentrations of all the ferroelectric films 131 in the ferroelectric layer 13 may be distributed in a high-low-high-low-high-low rule in the first direction F1 (for example, upward in the first direction F1). FIG. 8A and FIG. 8B are another diagram of a structure of a ferroelectric layer according to an embodiment of this application. FIG. 8A is a diagram of a distribution rule of oxygen vacancy concentrations of all ferroelectric films in the ferroelectric layer. FIG. 8B is a diagram of built-in electric field strength at different positions in the ferroelectric layer. In the figure, a vertical coordinate E represents built-in electric field strength, and a horizontal coordinate D represents a distance to a lower surface of the ferroelectric layer (a surface that is of the ferroelectric layer and that is close to a side of the first electrode). As shown in FIG. 8A and FIG. 8B, the oxygen vacancy concentrations of all the ferroelectric films 131 in the ferroelectric layer 13 may be distributed in a low-high-low-high-low-high rule in the first direction F1 (for example, upward in the first direction F1).

FIG. 9A and FIG. 9B are another diagram of a structure of a ferroelectric layer according to an embodiment of this application. FIG. 9A is a diagram of a distribution rule of oxygen vacancy concentrations of all ferroelectric films in the ferroelectric layer. FIG. 9B is a diagram of built-in electric field strength at different positions in the ferroelectric layer. In the figure, a vertical coordinate E represents built-in electric field strength, and a horizontal coordinate D represents a distance to a lower surface of the ferroelectric layer (a surface that is of the ferroelectric layer and that is close to a side of the first electrode). As shown in FIG. 9A and FIG. 9B, the oxygen vacancy concentrations of all the ferroelectric films 131 in the ferroelectric layer 13 may be distributed in a rule of first increasing and then decreasing in the first direction F1 (for example, upward in the first direction F1). Alternatively, the oxygen vacancy concentrations of all the ferroelectric films 131 in the ferroelectric layer 13 may be distributed in a rule of first decreasing and then increasing in the first direction F1.

With reference to FIG. 7A to FIG. 9B, the foregoing describes several distribution rules of the oxygen vacancy concentrations of all the ferroelectric films 131 in the ferroelectric layer 13. During actual application, a quantity of layers and a distribution rule of the oxygen vacancy concentrations of the ferroelectric films 131 in the ferroelectric layer 13 may be set based on an actual requirement. Examples are not provided herein one by one.

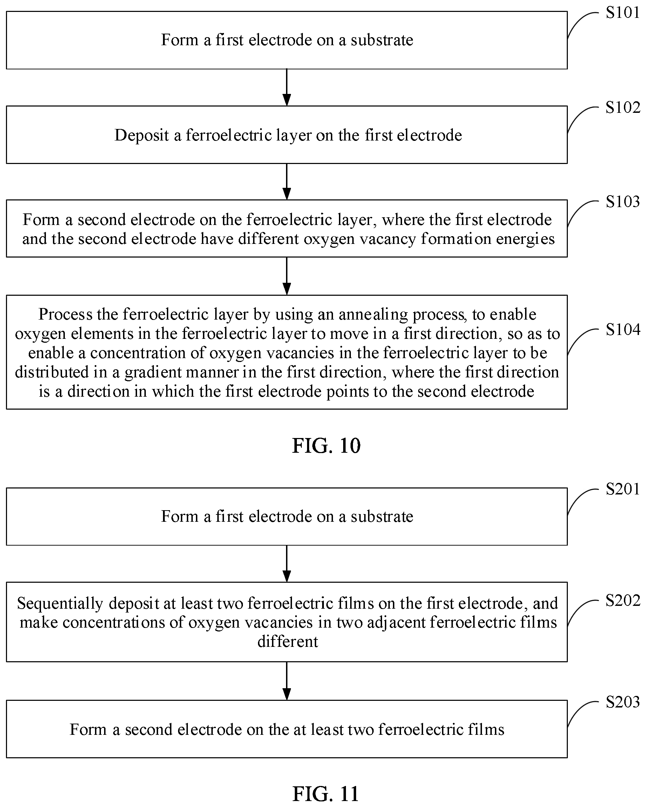

Based on a same technical concept, an embodiment of this application further provides a method for manufacturing a memory cell. FIG. 10 is a flowchart of the method for manufacturing a memory cell according to an embodiment of this application. As shown in FIG. 10, the method for manufacturing a memory cell according to this embodiment of this application may include the following steps:
S101: forming a first electrode on a substrate;
S102: depositing a ferroelectric layer on the first electrode;
S103: forming a second electrode on the ferroelectric layer, where the first electrode and the second electrode have different oxygen vacancy formation energies; and
S104: processing the ferroelectric layer by using an annealing process, to enable oxygen elements in the ferroelectric layer to move in a first direction, so as to enable a concentration of oxygen vacancies in the ferroelectric layer to be distributed in a gradient manner in the first direction, where the first direction is a direction in which the first electrode points to the second electrode.

In this embodiment of this application, the first electrode and the second electrode with different oxygen vacancy formation energies are manufactured. In the subsequent annealing process, an electrode with a higher oxygen vacancy formation energy may absorb the oxygen elements in the ferroelectric layer, so that the oxygen elements in the ferroelectric layer move in the first direction, and the concentration of the oxygen vacancies in the ferroelectric layer is distributed in the gradient manner in the first direction. In this way, a uniform built-in electric field is formed in the ferroelectric layer, thereby improving uniformity of a polarization orientation of a ferroelectric phase in the ferroelectric layer and improving performance of the ferroelectric memory.

The memory cell in this embodiment of this application may be a hafnium oxide-based ferroelectric memory cell. In S102, the ferroelectric layer may be made of a hafnium oxide material. For example, the ferroelectric layer may be made of a zirconium-doped hafnium oxide (HfxZr1-xO, HZO) material. Certainly, in some cases, the ferroelectric layer may alternatively be made of another ferroelectric material. In a possible implementation, the ferroelectric layer may be manufactured by using an atomic layer deposition (atomic layer deposition, ALD) process.

Refer to FIG. 3. In S101 and S103, the first electrode 11 and the second electrode 12 may be manufactured by using different chemical ratios, and a dangling bond that can absorb oxygen is formed in one of the electrodes, so that the first electrode 11 and the second electrode 12 have different oxygen vacancy formation energies. For example, a dangling bond that can absorb oxygen is formed in the second electrode 12. In S104, the ferroelectric layer 13 is processed by using the annealing process, so that a ferroelectric material in the ferroelectric layer 13 is crystallized. For example, the ferroelectric layer 13 may be processed by using a rapid thermal annealing process. In the annealing process, the dangling bond in the second electrode 12 may absorb oxygen atoms in the ferroelectric layer 13, so that more oxygen vacancies are formed in the ferroelectric layer 13 at the second interface Q2. Instead, the first electrode 11 causes fewer oxygen vacancies in the ferroelectric layer 13 at the first interface Q1. Therefore, an oxygen vacancy concentration difference can be formed in the ferroelectric layer 13 at the first interface Q1 and the second interface Q2, to form the uniform built-in electric field in the ferroelectric layer 13.

In a possible implementation, the first electrode and the second electrode each may include a compound material. Specifically, the first electrode 11 and the second electrode 12 each may include a first element and a second element, where the first element is a metal element, and the second element is a non-metal element. An atomic count ratio of the first element to the second element in the first electrode 11 is different from an atomic count ratio of the first element to the second element in the second electrode 12. In this way, an oxygen vacancy formation energy of the first electrode 11 can be different an oxygen vacancy formation energy of the second electrode 12. In S101 and S103, the first electrode 11 and the second electrode 12 may be manufactured by using different chemical ratios, so that the first electrode 11 and the second electrode 12 obtained through manufacturing are different in the atomic count ratio of the first element to the second element. For example, the first element may be an element like Ti, Ta, or Al, and the second element may be an element like N, P, or As. Optionally, the first electrode 11 may include one or a combination of TiN, TaN, TiAlN, TiSiN, TaAlN, and TiAlCN, and the second electrode 12 may include one or a combination of TiN, TaN, TiAlN, TiSiN, TaAlN, and TiAlCN.

In an embodiment, the first electrode 11 and the second electrode 12 may be made of a same material. For example, the first electrode 11 and the second electrode 12 each may include a TiN material, or the first electrode 11 and the second electrode 12 each may include a TaN material. In another embodiment, the first electrode 11 and the second electrode 12 may be made of different materials. For example, the first electrode 11 may include a TiN material, and the second electrode 12 may include a TaN material; or the first electrode 11 may include a TiAlN material, and the second electrode 12 may include a TiN material. During specific implementation, materials of the first electrode 11 and the second electrode 12 may be set based on an actual requirement. Examples are not provided herein one by one.

In another possible implementation, the first electrode may include a metal material, and the second electrode may include a compound material. For example, the first electrode 11 may include metal materials such as metal W, Al, and Cu, and the second electrode 12 may include a first element and a second element, where the first element is a metal element, and the second element is a non-metal element. For example, the first element may be another metal element like Ti, Ta, or Al, and the second element may include another non-metal material like N, P, or As. The second electrode may have a dangling bond of the first element; or the second electrode may have a dangling bond of the second element. In this way, an oxygen vacancy concentration of the ferroelectric layer at the first interface can be different from that at the second interface.

The memory cell in Embodiment 1 may be manufactured by using the manufacturing method shown in FIG. 10. For a specific implementation of the manufacturing method shown in FIG. 10, refer to the specific implementation of the memory cell in Embodiment 1. Repeated parts are not described herein again.

Based on a same technical concept, an embodiment of this application further provides a method for manufacturing a memory cell. FIG. 11 is a flowchart of another method for manufacturing a memory cell according to an embodiment of this application. As shown in FIG. 11, the method for manufacturing a memory cell according to this embodiment of this application may include the following steps:
S201: forming a first electrode on a substrate;
S202: sequentially depositing at least two ferroelectric films on the first electrode, and making concentrations of oxygen vacancies in two adjacent ferroelectric films different; and
S203: forming a second electrode on the at least two ferroelectric films.

In this embodiment of this application, the at least two ferroelectric films are sequentially deposited on the first electrode, and the concentrations of the oxygen vacancies in the two adjacent ferroelectric films are different, so that a concentration of oxygen vacancies in a ferroelectric layer can be distributed in a gradient manner. Therefore, a uniform built-in electric field can be formed in the ferroelectric layer, and a direction of the built-in electric field is consistent with a first direction (a direction in which the first electrode points to the second electrode), so that a polarization direction of a ferroelectric phase is induced to be also distributed in the first direction.

The memory cell in this embodiment of this application may be a hafnium oxide-based ferroelectric memory cell. In S202, each ferroelectric film in the ferroelectric layer may be made of a hafnium oxide material. For example, the ferroelectric film may be made of a zirconium-doped hafnium oxide (HfxZr1-xO, HZO) material. Certainly, in some cases, the ferroelectric film may alternatively be made of another ferroelectric material.

Refer to FIG. 6A. In S202, each ferroelectric film 131 may be manufactured by using an atomic layer deposition (atomic layer deposition, ALD) process. In a process of depositing each ferroelectric film 131, ferroelectric films 131 with different oxygen vacancy concentrations may be formed by controlling a dose of oxygen (O-dose). Specifically, the dose of oxygen may be adjusted by controlling parameters such as a residence time, a concentration, or a flow rate of oxygen. For example, when the ferroelectric layer 13 includes a zirconium-doped hafnium oxide (HfxZr1-xO, HZO) material, a concentration of oxygen vacancies in the ferroelectric film 131 may be controlled by adjusting parameters such as a residence time, a concentration, or a flow rate of an oxygen (O) element, a zirconium (Zr) element, or a hafnium (Hf) element.

Specifically, in S202, a thickness of a single deposited ferroelectric film 131 may be 0.5 nm to 2 nm. For example, the thickness of the ferroelectric film 131 may be 0.5 nm, 1 nm, 1.5 nm, or 2 nm. A total thickness of the ferroelectric layer 13 obtained by stacking all ferroelectric films 131 may be within a range of 5 nm to 15 nm. For example, the total thickness of the ferroelectric layer 13 may be 5 nm, 8 nm, 10 nm, 12 nm, or 15 nm.

In a possible implementation, as shown in FIG. 7A to FIG. 8B, oxygen vacancy concentrations of all the ferroelectric films 131 in the ferroelectric layer 13 may be distributed in a high-low alternating manner in the first direction F1. Refer to FIG. 7A and FIG. 7B. The oxygen vacancy concentrations of all the ferroelectric films 131 in the ferroelectric layer 13 may be distributed in a high-low-high-low-high-low rule in the first direction F1 (for example, upward in the first direction F1). Alternatively, refer to FIG. 8A and FIG. 8B. The oxygen vacancy concentrations of all the ferroelectric films 131 in the ferroelectric layer 13 may be distributed in a low-high-low-high-low-high rule in the first direction F1 (for example, upward in the first direction F1). In another possible implementation, refer to FIG. 9A and FIG. 9B. The oxygen vacancy concentrations of all the ferroelectric films 131 in the ferroelectric layer 13 may be distributed in a rule of first increasing and then decreasing in the first direction F1 (for example, upward in the first direction F1). Alternatively, the oxygen vacancy concentrations of all the ferroelectric films 131 in the ferroelectric layer 13 may be distributed in a rule of first decreasing and then increasing in the first direction F1. During actual application, a quantity of layers and a distribution rule of the oxygen vacancy concentrations of the ferroelectric films 131 in the ferroelectric layer 13 may be set based on an actual requirement. Examples are not provided herein one by one.

The memory cell in Embodiment 2 may be manufactured by using the manufacturing method shown in FIG. 11. For a specific implementation of the manufacturing method shown in FIG. 11, refer to the specific implementation of the memory cell in Embodiment 2. Repeated parts are not described herein again.

In conclusion, in this embodiment of this application, the concentration of the oxygen vacancies in the ferroelectric layer are set to be distributed in the gradient manner in the first direction (the first direction is a direction in which the first electrode points to the second electrode), so that texture orientations of ferroelectric domains can be changed, and uniformity of a polarization orientation of the ferroelectric phase in the ferroelectric layer can be improved, thereby improving performance of a ferroelectric memory. For example, a coercive field (coercive electric field, Ec) of the ferroelectric memory can be reduced, remnant polarization (remnant polarization, Pr) can be increased, and uniformity of performance of a small-sized ferroelectric memory is improved. In addition, the technical solutions in this embodiment of this application are not dependent on a specific electrode material or a thickness of a ferroelectric film, have a wide application scope, and have low process costs.

Based on a same technical concept, an embodiment of this application further provides a ferroelectric memory. The ferroelectric memory in this embodiment of this application may be a hafnium oxide-based ferroelectric memory. Certainly, the ferroelectric memory in this embodiment of this application may alternatively be a ferroelectric memory including another ferroelectric material. The ferroelectric memory in this embodiment of this application may be any type of memory, for example, a ferroelectric random access memory (ferroelectric random access memory, FeRAM or FRAM), a ferroelectric field effect transistor (ferroelectric field effect transistor, FeFET) memory, or a ferroelectric tunnel junction (ferroelectric tunnel junction, FTJ) memory.

The ferroelectric memory provided in this embodiment of this application may include a controller and any one of the foregoing memory cells, where the memory cell is electrically connected to the controller. Because the uniformity of the polarization orientation of the ferroelectric phase in the memory cell is high, performance of the ferroelectric memory including the memory cell is good.

Based on a same technical concept, an embodiment of this application further provides an electronic device. The electronic device in this embodiment of this application may be any electronic device having a storage function. For example, the electronic device in this embodiment of this application may be a mobile phone, a tablet computer, a desktop computer, an intelligent wearable device, a vehicle-mounted device, a server, a processor, or the like.

The electronic device provided in this embodiment of this application may include a circuit board and any one of the foregoing ferroelectric memories, where the ferroelectric memory is electrically connected to the circuit board. Because the ferroelectric memory has high performance, performance of the electronic device including the ferroelectric memory is also good.

Although preferred embodiments of this application have been described, a person skilled in the art can make changes and modifications to these embodiments once learning the basic inventive concept. Therefore, the appended claims are intended to be construed as to cover the preferred embodiments and all changes and modifications falling within the scope of this application.

Clearly, a person skilled in the art can make various modifications and variations to embodiments of this application without departing from the spirit and scope of embodiments of this application. In this case, this application is intended to cover these modifications and variations of embodiments of this application provided that they fall within the scope of protection defined by the following claims and their equivalent technologies.

## Claims

1. A memory cell, comprising a first electrode, a second electrode, and a ferroelectric layer, wherein
the ferroelectric layer is located between the first electrode and the second electrode; and
a concentration of oxygen vacancies in the ferroelectric layer is distributed in a gradient manner in a first direction, and the first direction is a direction in which the first electrode points to the second electrode.

2. The memory cell according to claim 1, wherein the first electrode and the second electrode have different oxygen vacancy formation energies; and
an oxygen vacancy concentration of the ferroelectric layer at a first interface is different from an oxygen vacancy concentration of the ferroelectric layer at a second interface, wherein the first interface is an interface of contact between the ferroelectric layer and the first electrode, and the second interface is an interface of contact between the ferroelectric layer and the second electrode.

3. The memory cell according to claim 1 or 2, wherein the first electrode and the second electrode each comprise a first element and a second element, the first element is a metal element, and the second element is a non-metal element; and
an atomic count ratio of the first element to the second element in the first electrode is different from an atomic count ratio of the first element to the second element in the second electrode.

4. The memory cell according to claim 3, wherein the first electrode comprises one or a combination of TiN, TaN, TiAlN, TiSiN, TaAlN, and TiAlCN; and
the second electrode comprises one or a combination of TiN, TaN, TiAlN, TiSiN, TaAlN, and TiAlCN.

5. The memory cell according to claim 1 or 2, wherein the first electrode comprises a metal material;
the second electrode comprises a first element and a second element, wherein the first element is a metal element, and the second element is a non-metal element; and
the second electrode has a dangling bond of the first element, or the second electrode has a dangling bond of the second element.

6. The memory cell according to any one of claims 1 to 5, wherein the ferroelectric layer comprises at least two stacked ferroelectric films; and
concentrations of oxygen vacancies in two adjacent ferroelectric films are different.

7. The memory cell according to claim 6, wherein oxygen vacancy concentrations of all ferroelectric films in the ferroelectric layer are distributed in a high-low alternating manner in the first direction.

8. The memory cell according to claim 6, wherein oxygen vacancy concentrations of all ferroelectric films in the ferroelectric layer are distributed in a rule of first increasing and then decreasing or first decreasing and then increasing in the first direction.

9. A ferroelectric memory, comprising a controller and the memory cell according to any one of claims 1 to 8, wherein the memory cell is electrically connected to the controller.

10. An electronic device, comprising a circuit board and the ferroelectric memory according to claim 9, wherein the ferroelectric memory is electrically connected to the circuit board.

11. A method for manufacturing a memory cell, comprising:
forming a first electrode on a substrate;
depositing a ferroelectric layer on the first electrode;
forming a second electrode on the ferroelectric layer, wherein the first electrode and the second electrode have different oxygen vacancy formation energies; and
processing the ferroelectric layer by using an annealing process, to enable oxygen elements in the ferroelectric layer to move in a first direction, so as to enable a concentration of oxygen vacancies in the ferroelectric layer to be distributed in a gradient manner in the first direction, wherein the first direction is a direction in which the first electrode points to the second electrode.

12. A method for manufacturing a memory cell, comprising:
forming a first electrode on the substrate;
sequentially depositing at least two ferroelectric films on the first electrode, and making concentrations of oxygen vacancies in two adjacent ferroelectric films different; and
forming a second electrode on the at least two ferroelectric films.
